# EUROPEAN PATENT SPECIFICATION

(11) **EP 0 590 319 B1**
(45) Date of publication and mention of the grant of the patent: **14.01.1998**
(21) Application number: 93113747.5
(22) Date of filing: 27.08.1993
(51) Int. Cl.: H01L 29/788, H01L 21/336, G11C 16/04

(54) **A non-volatile memory cell**
Nichtflüchtige Speicherzelle
Cellule de mémoire rémanente

(30) Priority: 02.10.1992 JP 264518/92; 08.02.1993 JP 19846/93
(43) Date of publication of application: 06.04.1994
(73) Proprietor: MATSUSHITA ELECTRIC INDUSTRIAL CO., LTD., Kadoma-shi, Osaka 571 (JP)
(72) Inventor: Morii, Tomoyuki, Ibaragi-shi, Osaka (JP)
(74) Representative: Marx, Lothar, Dr.

(56) References cited:
- EP-A- 0 389 721
- EP-A- 0 517 353
- US-A- 5 101 250
- US-A- 5 143 860
- PATENT ABSTRACTS OF JAPAN vol. 9, no. 201 (E-336)(1924) 17 August 1985 & JP-A-60 065 576
- PATENT ABSTRACTS OF JAPAN vol. 17, no. 223 (E-1359) 7 May 1993 & JP-A-04 356 969

## Description

### BACKGROUND OF THE INVENTION

### 1. Field of the Invention:

The present invention relates to a non-volatile memory cell of a side wall accumulation type, and more particularly to a non-volatile memory cell for an electrically erasable programmable read only memory (EEPROM).

### 2. Description of the Related Art:

A non-volatile memory includes erasable programmable read only memories (EPROMs) and EEPROMs.

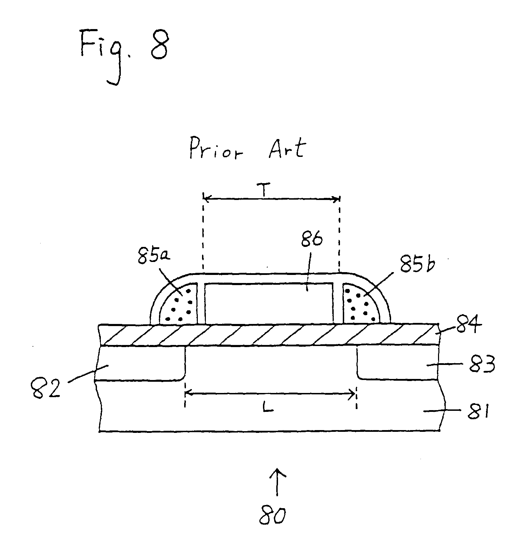

Figure **8** shows a non-volatile memory cell of a side wall accumulation type **80** for an EPROM. Such a memory cell is disclosed in U.S. Patent No. 5,051,793.

The memory cell **80** includes a p-type silicon substrate **81**, a source region **82** and a drain region **83** formed in the substrate **81**, a gate insulating film **84** with a uniform thickness formed on the substrate **81**, floating gate electrodes **85a** and **85b**, and a control gate electrode **86** formed on the gate insulating film **84**. The floating gate electrodes **85a** and **85b** are provided on both sides of the control gate electrode **86** as a pair of side walls. The floating gate electrodes **85a** and **85b** and the control electrode **86** are electrically insulated from each other by an insulating film formed therebetween. The width (**T**) of the control gate electrode **86** (i.e., the size in the channel length direction) is smaller than the channel length (**L**), and the floating gate electrodes **85a** and **85b** cover a part of a channel via the gate insulating film **84**.

When the electric potential of the drain region **83** is made sufficiently higher than that of the source region **82**, electrons emitted from the source region **82** are accelerated toward the drain region **83** in an electric field formed between the source region **82** and the drain region **83**. The accelerated electrons cause avalanche breakdown in the vicinity of the drain region **83**, generating a plurality of high energy electrons (hot electrons). Part of the generated hot electrons jump over the electric potential barrier of the gate insulating film **84** to be injected into the floating gate electrode **85b** on the side of the drain region **83**. When hot electrons are injected into the floating gate electrode **85b**, the electric potential of the floating gate electrode **85b** is lowered, resulting in an increase in the inversion threshold voltage of the memory cell **80**.

In this way, each memory cell takes one of two electrically stable states (i.e., logic "high" and logic "low") in accordance with the level of the inversion threshold voltage. As a result, each memory cell can store 1-bit data. For example, among a plurality of non-volatile memory cells formed in a matrix, the inversion threshold voltage of a desired memory cell is selectively set at a high level and those of the other memory cells are set at a low level, whereby desired data can be stored.

The above-mentioned non-volatile memory cell of a side wall accumulation type has the following problems:

The read error of data can be prevented by increasing the quantity of the hot electrons to be injected into the floating gate electrode **85b**. This necessitates that the electric field in the vicinity of the drain region **83** be made stronger. In order to make the electric field stronger, a higher electric potential should be applied to the drain region **83**. However, in the case where such a high electric potential is applied to the drain region **83**, a depletion layer formed in the vicinity of the pn junction between the n-type drain region **83** and the p-type substrate **81** deeply extends toward the source region **82**. As a result, the hot electrons generated due to the avalanche breakdown are injected into a portion of the gate insulating film **84** right under the control gate electrode **86**. In order to avoid the injection of the hot electrons into the gate insulating film **84**, the electric potential to be applied to the drain region **83** should be decreased. However, the decreased electric potential to be applied to the drain region **83** decreases the number of hot electrons (write capacity) to be injected into the floating gate electrode **85b**. This will cause a read error of data.

US-A-5,143,860 discloses an EPROM according to the preamble of claim 1 having side wall floating gates, which are formed on side walls of field insulators which overlie bit lines.

EP-A-0 517 353, which is published after the first the priory date of the present application, discloses a non-volatile memory cell with first and second impurity diffusion layers in a semiconductor substrate; a first insulating film is provided on said substrate between said layers on side of the first impurity diffusion layer; a tunnel dielectric film extend to the second impurity diffusion layer region. A first electrode is formed on said first insulating film and a floating gate is formed on the tunnel dielectric film and on the side wall of the first electrode through an insulating film. A second electrode is provided on the floating gate through a second insulating film to control the potential of the floating gate; channel hot electrons can be injected from the inversion layer formed under the first electrode controlled by said first electrode, to the floating gate.

### SUMMARY OF THE INVENTION

The non-volatile memory cell of this invention, includes:
a semiconductor layer of a first conductivity type having an upper portion;
a source region of a second conductivity type and a drain region of the second conductivity type which are provided in the upper portion of the semiconductor layer at a certain distance from each other;
a channel region provided between the source region and the drain region in the upper portion of the semiconductor layer;
an insulating film provided on the upper portion of the semiconductor layer, having a first portion covering substantially the source region, a second portion covering substantially the drain region, and a third portion covering the channel region;
a first floating gate electrode provided on the first portion of the insulating film;
a second floating gate electrode provided on the second portion of the insulating film; and
a control gate electrode provided on the third portion of the insulating film and electrically insulated from the first and second floating gate electrodes,
the thickness of both of the first portion and the second portion of the insulating film being smaller than that of the third portion of the insulating film.

In another embodiment of the present invention, the thickness of the first portion of the insulating film is equal to that of the second portion of the insulating film.

In another embodiment of the present invention, the thickness of the first portion of the insulating film is larger than that of the second portion of the insulating film.

According to another aspect of the present invention, a method for writing either one of three logic data: "0", "1" and "2" in the non-volatile memory cell described above, includes the steps of:
injecting part of the electric carriers in the source region into the first floating gate electrode through the first portion of the insulating film by applying a first voltage between the control gate electrode, and the source region and the drain region at the time of writing the data "1"; and
injecting part of the electric carriers in the source region and the drain region into the first floating gate electrode and the second floating gate electrode through the first portion and the second portion of the insulating film at the time of writing the data "2".

In one embodiment of the present invention, the control gate electrode completely covers the channel region.

In another embodiment of the present invention, the control gate electrode covers a part of the channel region, and at least one of the first and second floating gate electrodes covers another part of the channel region.

In the non-volatile memory cell of the present invention, the first portion and the second portion of the gate insulating film are thinner than the third portion thereof under the gate electrode. At the time of writing data, part of the electric carriers in the source region and the drain region are injected into the first floating gate electrode and/or the second floating gate electrode through the first portion and/or the second portion of the gate insulating film. In this way, data is written in the memory cell. The electrons flow through the first portion and/or the second portion of the gate insulating film due to a Fowler-Nordheim mechanism.

Thus, the invention described herein makes possible the advantage of providing a non-volatile memory cell of a side wall accumulation type with large write capacity.

This and other advantages of the present invention will become apparent to those skilled in the art upon reading and understanding the following detailed description with reference to the accompanying figures.

### BRIEF DESCRIPTION OF THE DRAWINGS

Figures **1A** to **1C** are cross-sectional views showing the steps of fabricating a non-volatile memory cell according to the present invention.

Figures **2A** to **2C** are cross-sectional views illustrating the operation of the memory cell shown in Figure **1C**.

Figure **3** is a graph showing the relationship between the drain current **I**_{**D**} and the drain voltage **V**_{**D**} in the memory cell shown in Figure **1C**.

Figures **4A** to **4C** are cross-sectional views showing the steps of fabricating another non-volatile memory cell according to the present invention.

Figures **5A** to **5D** are cross-sectional views illustrating the operation of the memory cell shown in Figure **4C**.

Figure **6** is a graph showing the relationship between the number of electric carriers to be injected into the floating gate electrode of the memory cell shown in Figure **4C** and the control gate voltage **V**_{**CG**} to be applied to the control gate electrode.

Figure **7** is a graph showing the relationship between the drain current **I**_{**D**} and the drain voltage **V**_{**D**} in the memory cell shown in Figure **4C**.

Figure **8** is a cross-sectional view showing an example of a conventional non-volatile memory cell of a side wall accumulation type.

### DESCRIPTION OF THE PREFERRED EMBODIMENTS

Hereinafter, the present invention will be described by way of illustrative examples with reference to the drawings.

### Example 1

Figure **1C** is a cross-sectional view showing a non-volatile memory cell of a side wall accumulation type according to the present invention. The present invention will be described by way of an exemplary memory cell fabricated by using a process for fabricating an LSI with a minimum size of 0.5 to 1.0 µm.

This memory cell includes an n-type source region **24** and an n-type drain region **25** facing each other at a certain distance (about 0.25 µm) and a channel region positioned between the source region **24** and the drain region **25**. The source region **2**4 and the drain region **25** are provided in the upper portion of a p-type silicon substrate **11**. The source region **24** and the drain region **25** are an impurity diffusion region with a thickness of about 0.1 µm. The surface concentration of n-type impurities doped in the impurity diffusion regions is 10²⁰⁻²¹ cm⁻³. In the silicon substrate **11**, p-type impurities with a surface concentration of about 10¹⁷ cm⁻³ are doped.

On the silicon substrate **11**, a gate insulating film **13** is provided. The gate insulating film **13** includes a first portion **13a**, a second portion **13b**, and a third portion **13c**. The first portion **13a** has a thickness of 10 nm and covers the source region **24**, the second portion **13b** has a thickness of 10 nm and covers the drain region **25**, and the third portion **13c** has a thickness of 20 nm and covers the channel region. In the present example, the first portion **13a** and the second portion **13b** has the same thickness and both of the first and second portions **13a** and **13b** are thinner than the third portion **13c**. It is required that the thickness of the first portion **13a** and the second portion **13b** is set so that Fowler-Nordheim current (FN current) flows therethrough (i.e., about 5 nm or more). Moreover, it is required that the thickness of the third portion **13c** is larger than those of the first and second portions **13a** and **13b**. Furthermore, the third portion **13c** may have a multi-layered structure including an oxide film and a silicon nitride film.

A first floating gate electrode **17a** is provided on the first portion **13a**, and a second floating gate electrode **17b** is provided on the second portion **13b**. In addition, the control gate electrode **14** is provided on the third portion **13c**. The control gate electrode **14** is electrically insulated from the first floating gate electrode **17a** and the second floating gate electrode **17b** by an insulating film **12** with a thickness of 15 nm. The control gate electrode **14** and the floating gate electrodes **17a** and **17b** are typically made of polycrystalline silicon, polycide, etc.

The gate length of the control gate electrode **14** of the present example (measured along the channel length direction) is about 0.25 µm, and the gate width thereof (measured along the direction vertical to the channel length direction) is about 2 µm. The gate length of the floating gate electrodes **17a** and **17b** is about 0.1 to 0.15 µm, and the gate width thereof is equal to that of the control gate electrode **14**.

As shown in Figure **1C**, the memory cell is covered with an interlevel insulator **18** formed on the silicon substrate **11**. Contact holes are provided in the interlevel insulator **18** so as to reach the source region **24** and the drain region **25**. In addition, above the silicon substrate **11**, a source electrode **20S** and a drain electrode **20D** are provided. The source electrode **20S** comes into contact with the source region **24** through the contact hole and the drain electrode **20D** which comes into contact with the drain region **25** through the contact hole.

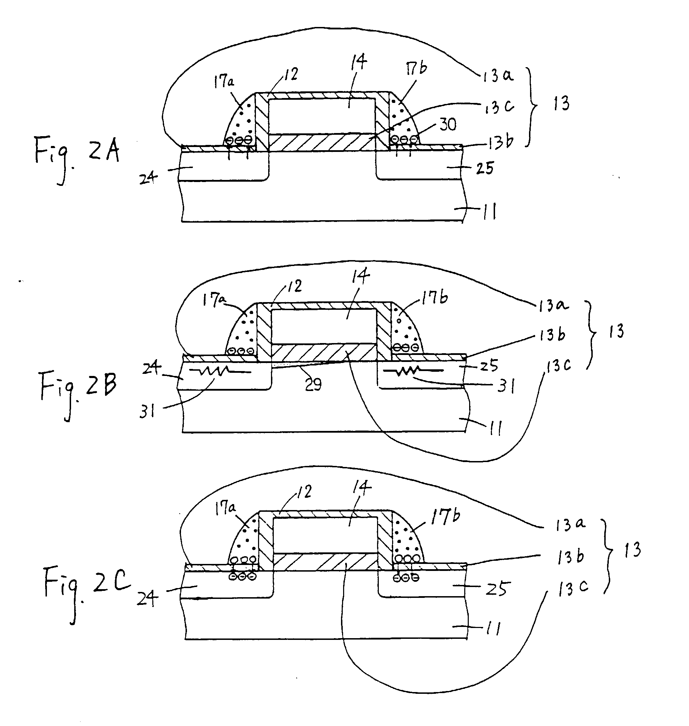

Hereinafter, the operation of the memory cell will be described with reference to Figures **2A** to **2C**.

First, a write operation will be described.

Electric potentials of 10 V, 0 V and 0 V are respectively applied to the control gate electrode **14**, the source region **24** (source electrode **20S**) and the drain region **25** (drain electrode **20D**). The electric potential of the control gate electrode **14** becomes 10 V with respect to the source region **24** and the drain region **25**. Due to the capacitive coupling of the floating gate electrodes **17a** and **17b** and the control gate electrode **14**, the electric potential of the floating gate electrodes **17a** and **17b** increases to a level required for generating an FN current. As a result, as shown in Figure **2A**, electrons in the source region **24** and in the drain region **25** pass through the first and second portions **13a** and **13b** because of the tunnel effect and are injected into the floating gate electrodes **17a** and **17b**, respectively. After the electrodes are injected into the floating gate electrodes **17a** and **17b**, even though the electric potential of the control gate electrode **14** is decreased below 10 V, the electrons are retained in the floating gate electrodes **17a** and **17b**, because the floating gate electrodes **17a** and **17b** are respectively covered with the first and second portions **13a** and **13b**, the interlevel insulator **18**, and the insulating film **12**.

Among a plurality of memory cells, the control gate electrodes **14** of selected memory cells are applied with an electric potential of 10 V and the control gate electrodes **14** of the other memory cells are applied with an electric potential of 0 V. In this way, electrons are accumulated only in the floating gate electrodes **17a** and **17b** of the selected memory cells.

Next, the read operation of the memory cell will be described.

Electric potentials of 5 V, 0 V and 1 V are respectively applied to the control gate electrode **14**, the source region **24** and the drain region **25**, respectively. In the present example, the inversion threshold voltage of the memory cell is set at a value lower than 5 V (e.g., 1 V), so that a conductive channel **29** is formed between the source region **24** and the drain region **25**, as shown in Figure **2B**. Electrons transfer from the source region **24** to the drain region **25** through the conductive channel **29**. At this time, a drain current at a certain level is obtained.

In the present example, since the floating gate electrodes **17a** and **17b** are positioned outside the channel region, the inversion threshold voltage of the memory cell in the case where the electrons are not accumulated in the floating gate electrodes **17a** and **17b** is substantially equal to that in the case where the electrons are accumulated in the floating gate electrodes **17a** and **17b**. For this reason, in both cases, the similar conductive channel **29** is formed between the source region **24** and the drain region **25**, and in both cases, the electrons transfer from the source region **24** to the drain region **25**, whereby a drain current can be obtained. However, as shown in Figure **2B**, when the electrons are accumulated in the floating gate electrodes **17a** and **17b**, the accumulated electrons increase the diffusion layer resistance (i.e., parasitic resistance **31**) of the source region **24** and the drain region **25**. Because of this, the level of the drain current obtained in the case where the electrons are accumulated in the floating gate electrodes **17a** and **17b** is lower than that of the drain current obtained in the case where the electrons are not accumulated in the floating gate electrodes **17a** and **17b**.

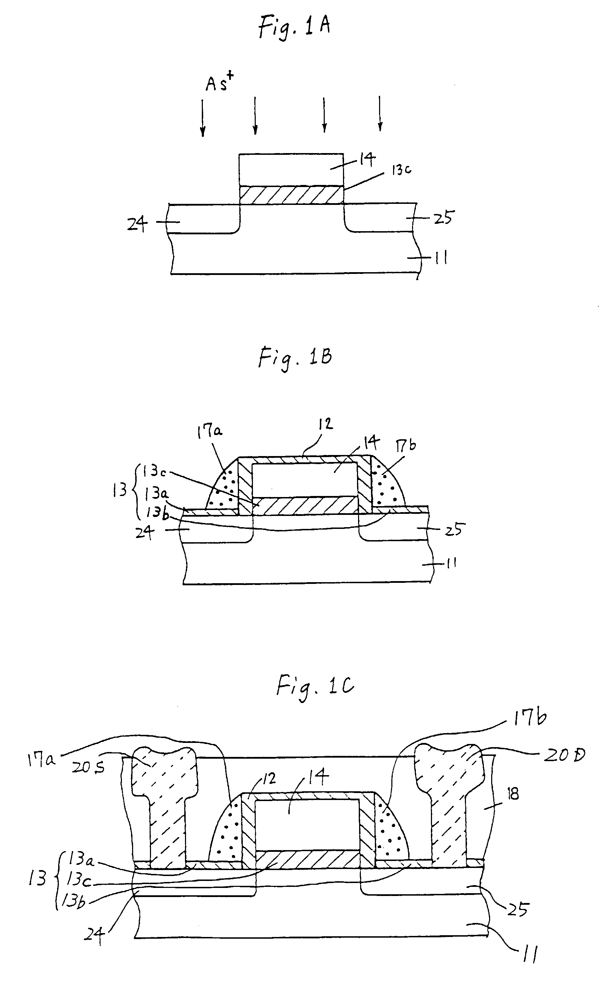

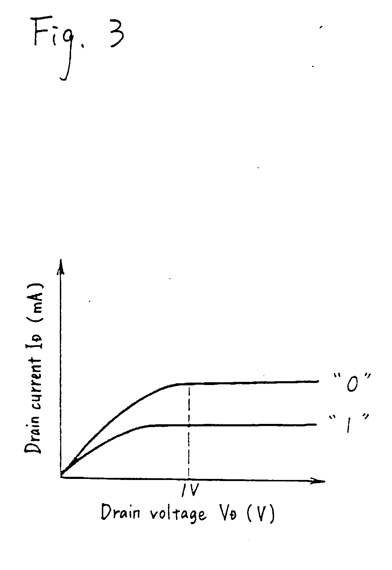

Figure **3** shows the relationship between the drain current **I**_{**D**} and the drain voltage **V**_{**D**}. As is understood from Figure **3**, 1-bit data "0" and "1" are identified depending upon the level of the drain current **I**_{**D**}.

As described above, in the non-volatile memory cell of a side wall accumulation type according to the present invention, 1-bit data is not stored depending upon the level of the inversion threshold voltage. According to the present invention, 1-bit data is stored depending upon the level of the parasitic resistance **31** of the source region **24** and the drain region **25**. It is considered that when a number of electrons are accumulated in the floating gate electrodes **17a** and **17b**, because of the electric field formed by these electrons, the electrons present in the source region **24** and the drain region **25** in the vicinity of the floating gate electrodes **17a** and **17b** decrease in number, thereby increasing the electric resistance in these regions. Data can be identified based on the level of the drain current, since the level of the drain current varies depending upon the level of the parasitic resistance **31** of the source region **24** and the drain region **25**.

In the memory cell of the present invention, the drain current under the condition that data is written has a level of 90% to 100% of that of the drain current under the condition that the data is not written. In general, in order to practically perform the reading of data, it is considered that the drain current under the condition that data is written should have a level of 80% or less that of the drain current under the condition that data is not written. In addition, in order to perform the reading of data without error, it is preferred that the drain current under the condition that data is written has a level of 70% or less that of the drain current under the condition that data is not written.

In order that the drain current is greatly varied in accordance with the accumulation or non-accumulation of electrons in the floating gate electrodes **17a** and **17b**, for example, the gate length of the floating gate electrodes **17a** and **17b** is made larger, and the thickness of the first and second portions **13a** and **13b** is made smaller.

Next, the erase operation of the memory cell will be described.

Electric potentials of -10 V, 0 V and 0 V are respectively applied to the control gate electrode **14**, the source region **24** and the drain region **25**. The electric potentials of the floating gate electrodes **17a** and **17b** are sufficiently decreased due to the capacitive coupling between the control gate electrode **14** and the floating gate electrodes **17a** and **17b**. As a result, as shown in Figure **2C**, the electrons accumulated in the floating gate electrodes **17a** and **17b** transfer to the source region **24** and the drain region **25** therefrom.

The memory cell of the present example is different from that of Figure **8** in the following points:
(1) In the memory cell of Figure **8**, the electrons are injected from the channel region into the floating gate electrode **85b**. Because of this, a part of the floating gate electrode **85b** should cover a part of the channel region. On the other hand, in the memory cell of the present example, the electrons are injected from the source region **24** and the drain region **25** into the floating gate electrodes **17a** and **17b**, respectively. Because of this, it is not required that a part of the floating gate electrodes **17a** and **17b** cover a part of the channel region.
(2) In the memory cell of Figure **8**, hot electrons should be generated at the end of the channel region for the purpose of writing data. Part of the generated hot electrons are injected into the floating gate electrode **85b**; however, part of the remaining hot electrons tend to be trapped in the gate insulating film **84** above the channel region. On the other hand, in the memory cell of the present example, the electrons are injected from the source region **24** and the drain region **25** into the floating gate electrodes **17a** and **17b** because of an FN conduction mechanism. Therefore, the generation of hot electrons is not required for the purpose of writing data. Thus, according to the present invention, there is little possibility that the hot electrons are trapped in the third portion **13C** and that the reliability of the memory cell becomes degraded.
(3) In the memory cell of Figure **8**, the electrons accumulated in the floating gate electrodes **85a** and **85b** cannot be electrically removed, so that data stored in the memory cell cannot be electrically erased. In the memory cell of the present example, the electrons are injected taking advantage of the FN conduction mechanism, so that data stored in the memory cell can be electrically erased.

Next, a method for fabricating the above-mentioned memory cell will be described with reference to Figures **1A** to **1C**.

A relatively thick oxide film (thickness: 20 nm) to be the third portion **13c** is formed on the silicon substrate **11**. Then, a polycrystalline silicon film is formed on the oxide film by a CVD method. The polycrystalline silicon film is patterned to a predetermined wiring pattern by photolithography and etching to form the control gate electrode **14**. After this, the oxide film which is exposed is removed by etching. In this way, the remaining thick oxide film (i.e., the third portion **13c**) and the control gate electrode **14** cover the channel region in the silicon substrate **11**, as shown in Figure **1A**.

Then, As ions are implanted into the surface of the silicon substrate **11** using the control gate electrode **14** as a mask, and high concentration impurity diffusion regions (i.e., the source region **24** and the drain region **25**) are formed in a self-alignement with the control gate electrode **14**.

An insulating film **12** (thickness: 15 nm) which separates the floating gate electrode **17a** from the control gate electrode **14** and the floating gate electrode **17b** from the control gate electrode **14** is formed on both side faces of the control gate electrode **14**. After this, thin oxide films (thickness: 10 nm) are formed on the exposed surfaces of the silicon substrate **11**. These thin oxide films correspond to the first portion **13a** and the second portion **13b**.

Then, polycrystalline silicon is deposited over the entire surface of the silicon substrate **11** so as to cover the thin oxide films. The polycrystalline silicon is etched from the above by an etching technique with high anisotropy without using a mask. In this way, the polycrystalline silicon deposited on the regions other than those on both sides of the control gate electrode **14** is removed, thereby forming the floating gate electrodes **17a** and **17b** of a side wall accumulation type on both sides of the control gate electrode **14** (Figure **1B**).

Thereafter, the interlevel insulator **18** is formed, the contact holes are formed in the interlevel insulator **18**, and the source electrode **20S** and the drain electrode **20D** are formed by an ordinary technique. Thus, a structure as shown in Figure **1C** is obtained.

### Example 2

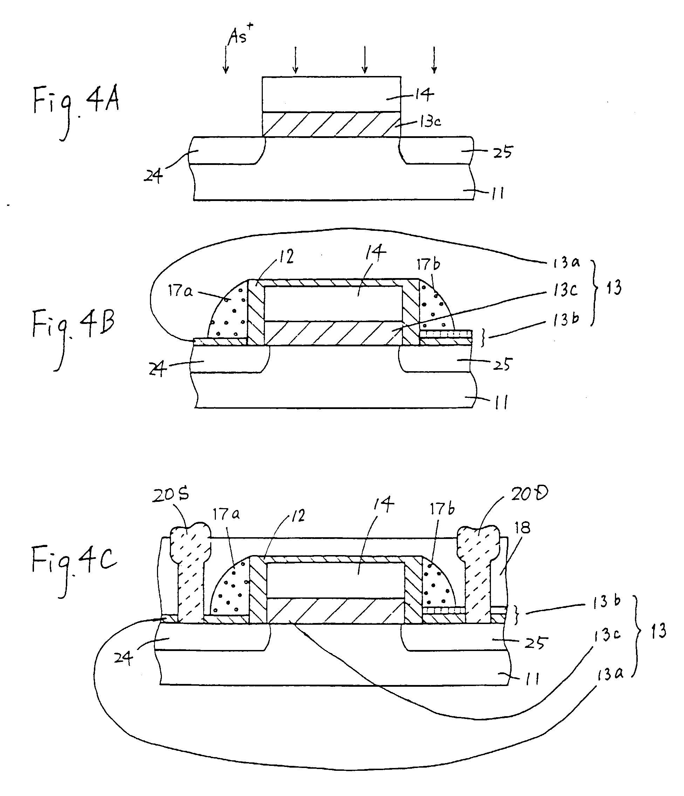

Hereinafter, another non-volatile memory cell of a side wall accumulation type according to the present invention will be described with reference to Figures **4A** to **4C**. Figure **4C** is a cross-sectional view of the memory cell. In this figure, the same reference numerals as those in the memory cell of Figure **1C** denote the same components. The principal difference between the memory cell of Figure **1C** and that of Example 2 lies in the structure of a gate insulating film.

Hereinafter, the present example will be shown by mainly describing the structure of a gate insulating film.

The gate insulating film **13** of the present example also includes the first portion **13a**, the second portion **13b**, and the third portion **13c**. The first portion **13a** has a thickness of 10 nm and covers the source region **24**, the second portion **13b** has a thickness of 15 nm and covers the drain region **25**, and the third portion **13c** has a thickness of 20 nm and covers the channel region. The first portion **13a** and the second portion **13b** are thinner than the third portion **13c**. In this respect, the present example has the same structure as in Example 1. However, in the present example, the first portion **13a** is thinner than the second portion **13b**, which is a different structure from that of Example 1. In the present example, the second portion **13b** has a two-layered structure.

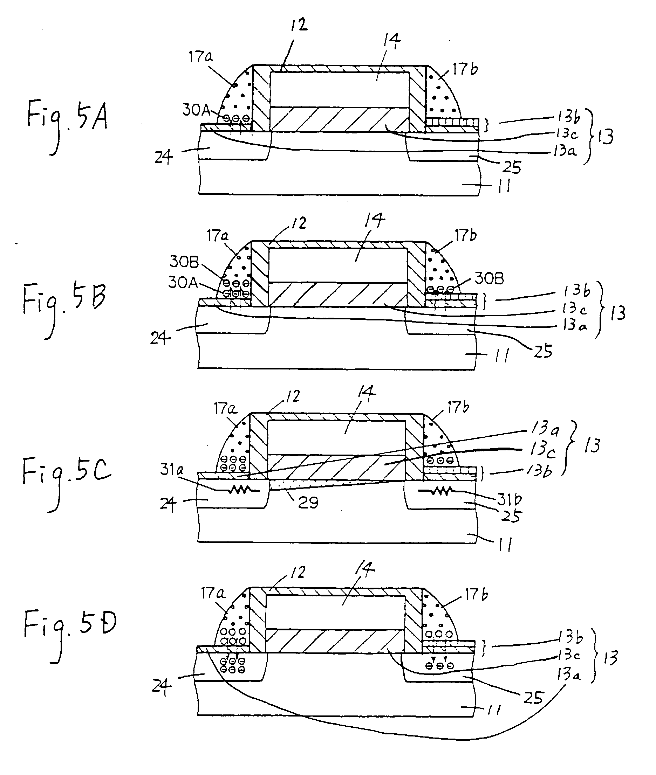

Hereinafter, the operation of the memory cell of the present example will be described with reference to Figures **5A** to **5D**.

First, the write operation of the memory cell will be described.

Electric potentials of 10 V, 0 V and 0 V are respectively applied to the control gate electrode **14**, the source region **24** (source electrode **20S**) and the drain region **25** (drain electrode **20D**). The electric potential of the floating gate electrodes **17a** and **17b** increases due to the capacitic coupling between the control gate electrode **14** and the floating gate electrodes **17a** and **17b**. As a result, as shown in Figure **5A**, the electrons in the source region **24** pass through the first portion **13a** because of the tunnel effect to be injected into the floating gate electrode **17a**. At this time, an FN current does not flow through the second portion **13b**. This is because the thickness of the second portion **13b** is set so that the FN current hardly flows therethrough even though the electric potential of 10 V is applied to the control gate electrode **14**. Even though the electric potential of the control gate electrode **14** is decreased below 10 V after the electrons are injected into the floating gate electrode **17a**, since the floating gate electrode **17a** is covered with the first portion **13a**, the interlevel insulator **18** and the insulating film **12**, the electrons are retained in the floating gate electrode **17a**.

Next, the case where electrons are injected into the floating gate electrodes **17a** and **17b** will be described.

Electric potentials of 15 V, 0 V and 0 V are respectively applied to the control gate electrode **14** and the source region **24** and the drain region **25**. The electric potentials of the floating gate electrodes **17a** and **17b** with respect to the source region **24** and the drain region **25** increase to a level required for generating the FN current. As a result, as shown in Figure **5B**, the electrons in the source region **24** and the drain region **25** pass through the first and second portions **13a** and **13b** because of the tunnel effect to be injected into the floating gate electrodes **17a** and **17b**. Even though the electric potential of the control gate electrode **14** is decreased below 15 V after the electrons are injected into the floating gate electrodes **17a** and **17b**, since the floating gate electrodes **17a** and **17b** are covered with the first and second portions **13a** and **13b**, the interlevel insulator **18**, and the insulating film **12**, the electrons are retained therein.

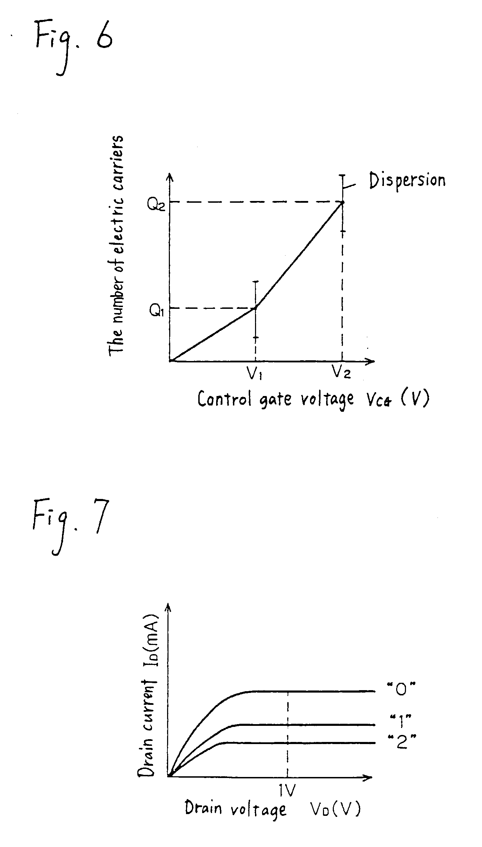

Figure **6** shows the relationship between the number of electric carriers accumulated in the floating gate electrodes **17a** and **17b** and the control gate voltage **V**_{**CG**} to be applied to the control gate electrode **14**. When the control gate voltage **V**_{**CG**} is below a first voltage **V1**, the number of electric carriers increases in proportion to the control gate voltage **V**_{**CG**}. When the control gate voltage **V**_{**CG**} is equal to the first voltage **V1**, the number of electric carriers is equal to **Q1**. On the other hand, when the control gate voltage **V**_{**CG**} is between the first voltage **V1** and a second voltage **V2**, the number of the electric carriers increases in proportion to the control gate voltage **V**_{**CG**}, and when the control gate voltage **V**_{**CG**} is equal to the second voltage **V2**, the number of electric carriers is equal to **Q2**. In particular, when the control gate voltage **V**_{**CG**} is between the first voltage **V1** and the second voltage **V2**, the number of electric carriers steeply increases in proportion to the control gate voltage **V**_{**CG**}. The reason for this is as follows:

When the control gate voltage **V**_{**CG**} is less than **V1**, the electrons are injected into only one of the floating gate electrodes **17**a and **17b**. When the control gate voltage **V**_{**CG**} is **V1** or more, the electrons are injected into both of the floating gate electrodes **17a** and **17b**.

As described above, in the memory cell of the present example, either one of the floating gate electrodes **17a** and **17b** is accumulated with electrons, both of the floating gate electrodes **17a** and **17b** are accumulated with the electrons, or the floating gate electrodes **17a** and **17b** are not accumulated with the electrons. Thus, in the present example, logic data of three values: "0", "1", and "2" can be written in each memory cell. In order to inject the electrons into both of the floating gate electrodes **17a** and **17b** or either one thereof, it is required to adjust the thickness of the first portion **13a**, that of the second portion **13b**, and the level of an electric potential (the first voltage **V1** and the second voltage **V2)** to be applied to the control gate electrode **14**. More specifically, the first and second voltages and the thickness of the first and second portions **13a** and **13b** are determined so that at the first voltage (e.g., 10 V), the electrons are injected into one of the floating gate electrodes (e.g., **17a**), and at the second voltage (e.g., 15 V), the electrons are injected into both of the floating gate electrodes **17a** and **17b**.

Next, the read operation of the memory cell will be described.

The read operation of the memory cell of the present example is conducted substantially in the same way as in Example 1. More specifically, electric potentials of 5 V, 0 V and 1 V are respectively applied to the control gate electrode **14**, the source region **24** and the drain region **25** to form the conductive channel **29**, as shown in Figure **5C**. The level of a current flowing between the source region **24** and the drain region **25** (i.e., drain current) is detected. The level of the drain current varies depending upon the level of parasitic resistance **31a** and **31b** shown in Figure **5C**. More specifically, the drain current increases in the following order ((1) → (2)→ (3)):
(1) The electrons are not accumulated in the floating gate electrodes **17a** and **17b**;
(2) The electrons are accumulated in one of the floating gate electrodes **17a** and **17b**; and
(3) The electrons are accumulated in both of the floating gate electrodes **17a** and **17b**.

Figure **7** shows the relationship between the drain current **I**_{**D**} and the drain voltage **V**_{**D**}. As shown in Figure **7**, logic values: "0", "1" and "2" are identified based on the level of the drain current.

The erase operation in the present example, as shown in Figure **5D**, is conducted substantially in the same way as in Example 1. In order that the electrons are discharged from both of the floating gate electrodes **17a** and **17b**, an electric potential to be applied to the control gate electrode **14** is adjusted, for example, at -15 V.

Next, a method for fabricating the above-mentioned memory cell will be described with reference to Figures **4A** to **4C**.

A relatively thick oxide film (thickness: 20 nm) which is to be the third portion **13c** is formed on the silicon substrate **11**. Then, a polycrystalline silicon film is formed on the oxide film by a CVD method. It is preferred that this oxide film is formed by a thermal oxidation method, considering the reliability of the memory cell. The surface of the oxide film can be nitrided in order to further improve the reliability.

Then, the polycrystalline silicon film is patterned to a predetermined wiring pattern to form the control gate electrode **14** by photolithography and etching. After this, the exposed oxide film is removed. In this way, the thick oxide film (i.e., the third portion **13c**) and the control gate electrode **14** cover the channel region of the silicon substrate **11**, as shown in Figure **4A**.

Then, As ions are implanted into the surface of the silicon substrate **11** using the control gate electrode **14** as a mask, and high concentration impurity diffusion regions (i.e., the source region **24** and the drain region **25**) are formed in a self-alignment with the control gate electrode **14**.

The insulating film **12** is formed on both side faces of the control gate electrode **14**. The insulating film **12** separates the floating gate electrode **17a** from the control gate electrode **14** and the floating gate electrode **17b** from the control gate electrode **14**. After this, thin oxide films are formed on the exposed surfaces of the silicon substrate **11**. These thin oxide films correspond to the first portion **13a** and the second portion **13b**.

Then, the thickness of the second portion **13b** is made larger than that of the first portion **13a**. There are the following methods for selectively making the thickness of the second portion **13b** larger than that of the first portion **13a**:
(1) A thin insulating film is formed on regions on the silicon substrate **11** (including the first portion **13a** and the second portion **13b**). Then, an etching mask is formed only on the second portion **13b**. After this, the thin insulating film provided on the regions which are not covered with this etching mask is partially etched, whereby the thin insulating film can be retained only on the second portion **13b**. As a result, the thickness of the second portion **13b** becomes larger by the thickness of this thin insulating film than that of the first portion **13a**.
(2) An oxidation barrier layer (e.g., a layer made of a silicon nitride film) is formed on regions on the silicon substrate **11** excluding the second portion **13b**. Then, the layered structure thus obtained is subjected to thermal oxidation. Because of this thermal oxidation, a thermal oxide film is grown only on the second portion **13b**. As a result, the thickness of the second portion **13b** becomes larger by the thickness of this thermal oxide film than that of the first portion **13a**.

After the thickness of the second portion **13b** is made larger than that of the first portion **13a** by either one of the above-mentioned methods, polycrystalline silicon is deposited over the entire surface of the silicon substrate **11** so as to cover the first and second portions **13a** and **13b**. The polycrystalline silicon is etched from the above by an etching technique with high anisotropy without using a mask. In this way, the polycrystalline silicon deposited on the regions other than those on both sides of the control gate electrode **14** is removed, thereby forming the floating gate electrodes **17a** and **17b** of a side wall accumulation type on both sides of the control gate electrode **14** (Figure **4B**).

Thereafter, the interlevel insulator **18** is formed, the contact holes are formed in the interlevel insulator **18**, and the source electrode **20S** and the drain electrode **20D** are formed by an ordinary technique. Thus, a structure as shown in Figure **4C** is obtained.

According to the present invention, a non-volatile memory cell with a side wall accumulation type having large write capacity is provided. Since hot electrons are not injected into the gate insulating film under the control gate electrode, high reliability of read of data can be realized.

In addition, according to the present invention, a single memory cell with a simplified structure can store data of a multiple logic values.

## Claims

1. A non-volatile memory cell comprising:
a) a semiconductor layer (11) of a first conductivity type having an upper portion;
b) a source region (24) of a second conductivity type and a drain region (25) of the second conductivity type which are provided in the upper portion of the semiconductor layer (11) at a certain distance from each other;
c) a channel region provided between the source region (24) and the drain region (25) in the upper portion of the semiconductor layer (11);
d) an insulating film (13) provided on the upper portion of the semiconductor layer (11), having a first portion (13a) covering substantially the source region (24), a second portion (13b) covering substantially the drain region (25), and a third portion (13c) covering the channel region;
e) a first floating gate electrode (17a) and a second floating gate electrode (17b); and
f) a control gate electrode (14) provided on the third portion (13c) of the insulating film (13) and electrically insulated from the first and second floating gate electrodes (17a, 17b)
**characterized** in that
g) the first floating gate electrode (17a) is provided on the first portion (13a) of the insulating film (13);
h) the second floating gate electrode (17b) is provided on the second portion (13b) of the insulating film (13); and
i) the thickness of both of the first portion (13a) and the second portion (13b) of the insulating film (13) is smaller than that of the third portion (13c) of the insulating film (13).

2. A non-volatile memory cell according to claim 1, wherein the thickness of the first portion (13a) of the insulating film (13) is equal to that of the second portion (13b) of the insulating film (13).

3. A non-volatile memory cell according to claim 1, wherein the thickness of the first portion (13a) of the insulating film (13) is larger than that of the second portion (13b) of the insulating film (13).

4. A non-volatile memory cell according to one of the preceding claims, wherein the control gate electrode (14) completely covers the channel region.

5. A non-volatile memory cell according to one of the claims 1 to 3, wherein the control gate electrode covers a part of the channel region, and at least one of the first and second floating gate electrodes (17a, 17b) covers another part of the channel region.

6. A method for writing either one of three logic data: "0", "1" and "2" in a non-volatile memory cell according to one of claims 3 to 5 as for as claims 4 and 5 refer to claim 3, comprising the steps of:
injecting part of the electric carriers in the source region (24) into the first floating gate electrode (17a) through the first portion (13a) of the insulating film (13) by applying a first voltage between the control gate electrode (14), and the source region (24) and the drain region (25) at a time of writing the data "1"; and
injecting part of the electric carriers in the source region (24) and the drain region (25) into the first floating gate electrode (17a) and the second floating gate electrode (17b) through the first portion (13a) and the second portion (13b) of the insulating film (13) at the time of writing the data "2".

## Patentansprüche

1. Nichtflüchtige bzw. permanente Speicherzelle mit:
a) einer Halbleiterschicht (11) eines ersten Leitfähigkeitstyps mit einem oberen Bereich;
b) einem Sourcebereich (24) eines zweiten Leitfähigkeitstyps und einem Drainbereich (25) des zweiten Leitfähigkeitstyps, welche in dem oberen Bereich der Halbleiterschicht (11) in einem bestimmten Abstand voneinander vorgesehen sind;
c) einem Kanalbereich, welcher zwischen dem Sourcebereich (24) und dem Drainbereich (25) im oberen Bereich der Halbleiterschicht (11) vorgesehen ist;
d) einem Isoliationsfilm (13), welcher auf dem oberen Bereich der Halbleiterschicht (11) vorgesehen ist, mit einem ersten Bereich (13a), welcher im wesentlichen den Sourcebereich (24) bedeckt bzw. abdeckt, einem zweiten Bereich (13b), welcher im wesentlichen den Drainbereich (25) bedeckt bzw. abdeckt, und einem dritten Bereich (13c), welcher den Kanalbereich bedeckt bzw. abdeckt;
e) einer ersten Floating Gate-Elektrode mit schwebenden bzw. feiem Potential (17a) und einer zweiten Floating Gate-Elektrode mit freiem bzw. schwebendem Potential (17b); und
f) einer Regel- bzw. Steuergateelektrode (14), welche auf dem dritten Bereich (13c) des Isolationsfilms (13) vorgesehen ist und elektrisch von den ersten und zweiten Floating Gate-Elektroden mit freiem Potential (17a, 17b) isoliert ist;
**dadurch gekennzeichnet**, daß
g) die erste Floating Gate-Elektrode mit schwebendem Potential (17a) auf dem ersten Bereich (13a) des Isolationsfilms (13) vorgesehen ist;
h) die zweite Floating Gate-Elektrode mit schwebendem Potential (17b) auf dem zweiten Bereich (13b) des Isolationsfilms (13) vorgesehen ist, und
i) die Dicke sowohl des ersten Bereichs (13a) als auch des zweiten Bereichs (13b) des Isolationsfilms (13) geringer ist als die des dritten Bereichs (13c) des Isolationsfilms (13).

2. Nichtflüchtige Speicherzelle nach Anspruch 1, wobei die Dicke des ersten Bereichs (13a) des Isolationsfilms (13) gleich der des zweiten Bereichs (13b) des Isolationsfilms (13) ist.

3. Nichtflüchtige Speicherzelle nach Anspruch 1, wobei die Dicke des ersten Bereichs (13a) des Isolationsfilms (13) größer ist als die des zweiten Bereichs (13b) des Isolationsfilms (13).

4. Nichtflüchtige Speicherzelle nach einem der vorhergehenden Ansprüche, wobei die Regel- bzw. Steuergateelektrode (14) den Kanalbereich vollständig bedeckt.

5. Nichtflüchtige Speicherzelle nach einem der Ansprüche 1 bis 3, wobei die Regel-bzw. Steuergateelektrode (14) einen Teil des Kanalbereichs bedeckt, und mindestens eine der ersten und zweiten Gateelektroden mit schwebendem Potential (17a, 17b) einen anderen Teil des Kanalbereichs bedeckt.

6. Verfahren zum Schreiben eines der drei logischen Daten: "0", "1" und "2" in eine nichtflüchtige Speicherzelle nach einem der Ansprüche 3 bis 5, soweit sich die Ansprüche 4 und 5 auf den Anspruch 3 beziehen, mit den Schritten:
- Injizieren eines Teils der elektrischen Ladungsträger in den Sourcebereich (24) in die erste Floating Gate-Elektrode mit schwebendem Potential (17a) durch den ersten Bereich (13a) des Isolationsfilms (13) durch Anlegen einer ersten Spannung zwischen die Regel- bzw. Steuergatelektrode (14) und den Sourcebereich (24) und dem Drainbereich (25) zu einer Zeit, zu der das Datum "1" geschrieben wird; und
- Injizieren eines Teils der elektrischen Ladungsträger in den Sourcebereich (24) und den Drainbereich (25) in die erste Floating Gate-Elektrode mit schwebendem Potential (17a) und die zweite Floating Gate-Elektrode mit schwebendem Potential (17b) durch den ersten Bereich (13a) und den zweiten Bereich (13b) des Isolationsfilms (13) zu der Zeit, zu welcher das Datum "2" geschrieben wird.

## Revendications

1. Cellule de mémoire rémanente comprenant :
a) une couche de semiconducteur (11) d'un premier type de conductivité comportant une partie supérieure,
b) une région de source (24) d'un second type de conductivité et une région de drain (25) du second type de conductivité, qui sont disposées dans la partie supérieure de la couche de semiconducteur (11) à une certaine distance l'une de l'autre,
c) une région de canal ménagée entre la région de source (24) et la région de drain (25) dans la partie supérieure de la couche de semiconducteur (11),
d) un film isolant (13) disposé sur la partie supérieure de la couche de semiconducteur (11), comportant une première partie (13a) recouvrant pratiquement la région de source (24), une seconde partie (13b) recouvrant pratiquement la région de drain (25) et une troisième partie (13c) recouvrant la région de canal,
e) une première électrode de grille flottante (17a) et une seconde électrode de grille flottante (17b), et
f) une électrode de grille de commande (14) disposée sur la troisième partie (13c) du film isolant (13) et électriquement isolée des première et seconde électrodes de grille flottante (17a, 17b)
caractérisée en ce que
g) la première électrode de grille flottante (17a) est disposée sur la première partie (13a) du film isolant (13),
h) la seconde électrode de grille flottante (17b) est disposée sur la seconde partie (13b) du film isolant (13), et
i) l'épaisseur de à la fois la première partie (13a) et la seconde partie (13b) du film isolant (13) est plus faible que celle de la troisième partie (13c) du film isolant (13).

2. Cellule de mémoire rémanente selon la revendication 1, dans laquelle l'épaisseur de la première partie (13a) du film isolant (13) est égale à celle de la seconde partie (13b) du film isolant (13).

3. Cellule de mémoire rémanente selon la revendication 1, dans laquelle l'épaisseur de la première partie (13a) du film isolant (13) est plus grande que celle de la seconde partie (13b) du film isolant (13).

4. Cellule de mémoire rémanente selon l'une quelconque des revendications précédentes, dans laquelle l'électrode de grille de commande (14) recouvre complètement la région de canal.

5. Cellule de mémoire rémanente selon l'une quelconque des revendications 1 à 3, dans laquelle l'électrode de grille de commande recouvre une partie de la région de canal, et au moins l'une de la première et de la seconde électrodes de grille flottante (17a, 17b) recouvre une autre partie de la région de canal.

6. Procédé d'écriture de l'une de trois données logiques : "0", "1" et "2" dans une cellule de mémoire rémanente selon l'une quelconque des revendications 3 à 5, dans la mesure où les revendications 4 et 5 se réfèrent à la revendication 3, comprenant les étapes consistant à :
injecter une partie des porteurs électriques dans la région de source (24) jusque dans la première électrode de grille flottante (17a) au travers de la première partie (13a) du film isolant (13) en appliquant une première tension entre l'électrode de grille de commande (14) et la région de source (24) et la région de drain (25) au moment de l'écriture de la donnée "1", et
injecter une partie des porteurs électriques dans la région de source (24) et la région de drain (25) jusque dans la première électrode de grille flottante (17a) et la seconde électrode de grille flottante (17b) au travers de la première partie (13a) et de la seconde partie (13b) du film isolant (13) au moment de l'écriture de la donnée "2".
